# EUROPEAN PATENT APPLICATION

(11) **EP 1 530 234 A2**
(43) Date of publication of application: **11.05.2005**
(21) Application number: 04077976.1
(22) Date of filing: 29.10.2004
(51) Int. Cl.: H01L 23/36

(54) **Heat sinkable power device package**

(30) Priority: 04.11.2003 US 701260
(71) Applicant: Delphi Technologies, Inc., Troy, MI 48007 (US)
(72) Inventor: Brandenburg, Scott D., Kokomo, IN 46902 (US); Oman, Todd P., Greentown, IN 46936 (US); Walsh, Matthew R., Sharpsville, IN 46068 (US)
(74) Representative: Denton, Michael John

(57) **Abstract**

A heat sinkable package that includes a power device package (200, 300, 400, 500) including an active side (A) and a non-active side (N) is disclosed. The non-active side (N) includes a heat sinkable surface positioned adjacent to a product case (C). Another embodiment of the invention is directed to a method for manufacturing a heat sinkable package. The method comprises the steps of placing at least one flip chip (204, 304) over a flexible circuit (208) within a mold tool; compensating for height variances of the flip chips (204, 204); and positioning an input/output on an active side (A) of the power device package (200, 300, 400, 500) opposite a non-active side (N) of the power device package.

## Description

### Technical Field

The present invention generally relates to power device packaging and, more particularly, to an improved packaging structure and heat sink for a power device.

### Background of the Invention

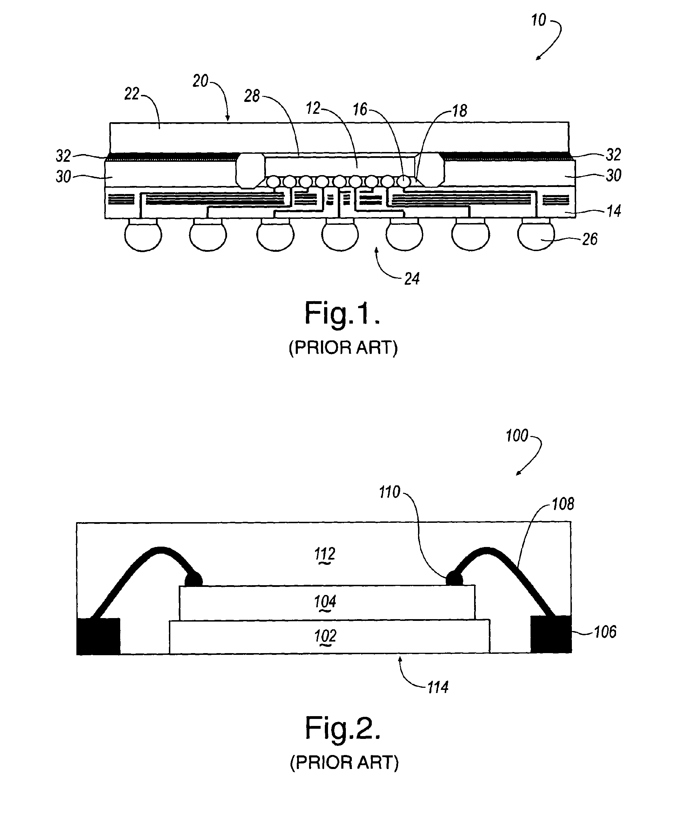

As seen in Figure 1, one example of a conventional power device package, which is seen generally at 10, comprises a flip chip 12 affixed to a printed wire board 14. Such power device packages may be used in a variety of applications such as consumer-, medical-, military-, or automotive-related fields. If applied in an automotive-related field, such power device packages 10 may be implemented in a power-train control module, an engine control module, a transmission control module, a braking control module, a steering control module, or the like.

The flip chip 12 is typically affixed to the printed wire board 14 by high temperature solder balls 16 and an underfilling epoxy resin 18. The top, non-active side of the package, which is generally seen at 20, includes a heat spreader, which is generally seen at 22. The heat spreader 22 typically comprises a heat sinkable material, such as, for example, copper. The bottom active side of the package, which is seen generally at 24, includes a plurality of low temperature solder balls 26 that will reflow at lower temperatures when attached to the circuit board (not shown). Although seen from a cross-sectional view as illustrated in Figure 1, the layout of the low temperature solder balls 26 may be in any desirable pattern, such as for example, a ball grid array (BGA) pattern, which essentially, defines a BGA power device package.

A thermally conductive adhesive, which is seen generally at 28, is intermediately located between the flip chip 12 and the heat spreader 22. The thermally conductive adhesive 28 may typically include a silver epoxy. The heat spreader 22 is carried by a support ring 30 that encompasses the flip chip 12 and is positioned adjacent to the printed wire board 14. Typically, similar in design to the heat spreader 22, the support ring 30 comprises a heat sinkable material, such as, for example, copper. The heat spreader 22 is secured to the support ring 30 by an upper layer of epoxy resin adhesive 32.

Although adequate for most applications, the power device package 10 includes multiple thermal interfaces. The thermal interfaces are located at the thermally conductive adhesive 28, the upper layer of epoxy resin 32, and at the top side 20 where a product heat sink (not shown) sinks the heat out to a product case (not shown). In design, the multiple thermal interfaces adequately sinks the heat from the power device package 10, however, the additional structure, including the heat spreader 22, adds to the cost of the power device package 10.

Other conventional power device packages not including multiple thermal interfaces do not provide an optimal heat sink path for flip chips. More specifically, such power device packages sink most of the heat through the circuit board, which results in poor removal of the heat from the applied integrated circuit and overall system. The circuit board is typically chosen as the heat sink out of design convenience and comprises a laminate material made out of epoxy glass, which, conversely, is an insulator and a relatively poor thermal conductor.

As seen in Figure 2, another conventional power device package, which is seen generally at 100, include chip and wire devices. The power device package 100 is typically referred to as a chip and wire quad-flat non-leaded package (QFN) that includes a copper lead frame 102 and a silicon integrated circuit (IC) 104. The power device package 100 is further defined to include a copper lead frame wire bond input-output (I/O) 106 connected to the silicon IC 104 by a gold or aluminum wire 108 and a gold ball bond 110. As illustrated, the power device package 100 is overmolded with a thermoset epoxy resin 112. Chip and wire QFN packages 100 are typically used more often than the flip chip BGA packages 10 because the chip and wire QFN package 100 does not include the multiple thermal interfaces. However, the chip and wire QFN package 100 undesirably includes the I/O and heat sink on the same surface, which is the bottom side of the package, which is seen generally at 114.

Although the power device package 10 illustrated in Figure 1 includes a single flip chip 12, defining a single chip module (SCM), power device packages 10 may include multiple flip chips 12, defining a multi-chip module (MCM). If MCMs are manufactured, height variances (i.e. a tolerance stack up) of the power device package 10 may occur, effecting the manufacturing consistency height of the packages. For example, upon reflowing, the collapse heights of the high temperature solder balls 16 may vary from approximately 3.0-3.5 mils. Even further, chips thicknesses vary from approximately 17-29 mils. Therefore, as a result, a need exists for a power device package that results in consistent manufacturing in the event of encountering tolerance stack up.

Accordingly, it is therefore desirable to provide a power device package including an improved heat sink structure and manufacturing consistency of the overall package.

### Summary of the Invention

The present invention relates to a heat sinkable package. Accordingly, one embodiment of the invention is directed to a heat sinkable package that includes a power device package including an active side and a non-active side. The non-active side includes a heat sinkable surface positioned adjacent to a product case. Another embodiment of the invention is directed to a method for manufacturing a heat sinkable package. The method comprises the steps of placing at least one flip chip over a flexible circuit within a mold tool; compensating for height variances of the flip chips; and positioning an input/output on an active side of the power device package opposite a non-active side of the power device package.

### Brief Description of the Drawings

The present invention will now be described, by way of example, with reference to the accompanying drawings, in which:
Figure 1 illustrates a conventional power device package;
Figure 2 illustrates another conventional power device package;
Figure 3 illustrates an assembly layout of the power device package according to one embodiment of the invention;
Figure 4 illustrates a side view of an assembled power device package according to Figure 3;
Figure 5 illustrates a bottom view of the power device package according to Figure 4;
Figure 6 illustrates a side view of a power device package according to another embodiment of the invention;
Figure 7 illustrates a bottom view of the power device package according to Figure 6;
Figure 8 illustrates a side view of a power device package according to another embodiment of the invention;
Figure 9 illustrates a bottom view of a power device package according to another embodiment of the invention;
Figure 10 illustrates a side view of a power device package according to Figure 9; and
Figure 11 illustrates a side view of the power device packages according to Figures 4 and 9 applied to a product case and circuit board.

### Description of the Preferred Embodiment

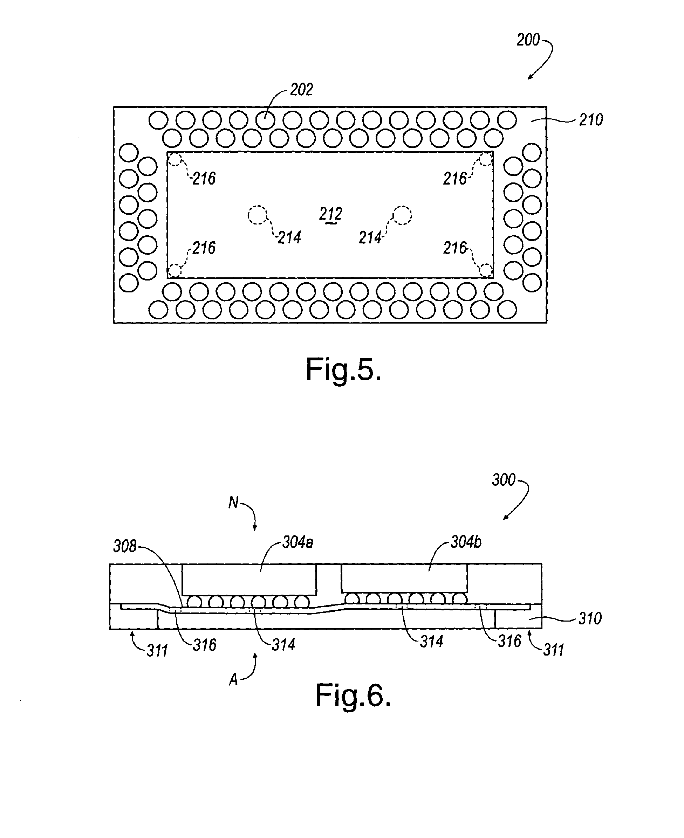

The above described disadvantages are overcome and a number of advantages are realized by the inventive power device packages, which are generally illustrated at 200, 300, 400, and 500 in Figures 5, 7, 9, and 11, respectively. It is contemplated that the power device packages may include either a SCM or a MCM packaging, including any desirable amount of chips. The inventive power device packages include a low thermal resistance IC junction to the product case that essentially provides a single thermal interface for the power device packages. Even further, if a flip chip is implemented in the power device package, consistent manufacturing of each power device package is ensured in view of associated tolerance stack up issues described above.

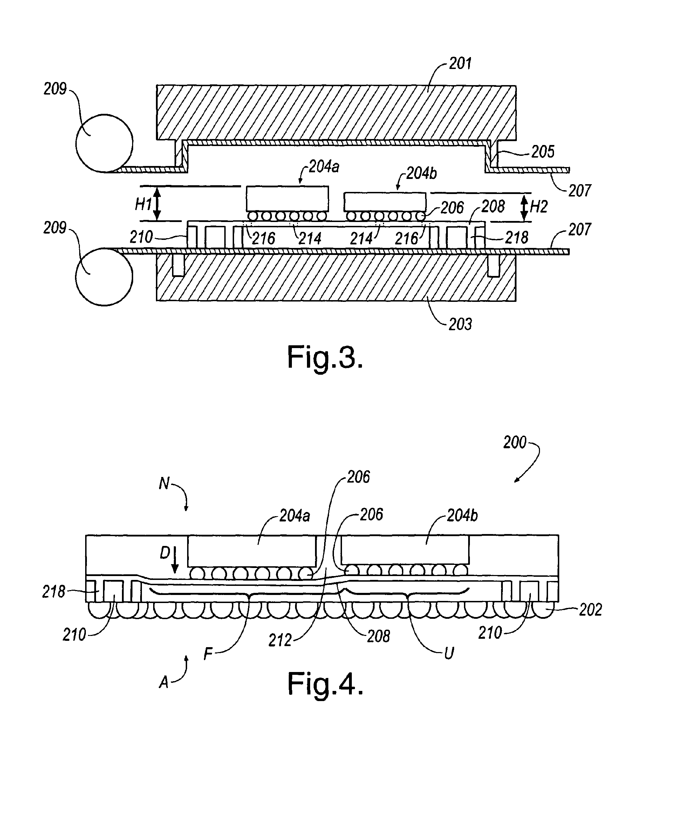

Referring initially to Figures 3-5, the power device package 200 generally includes a BGA of low temperature solder balls 202 (Figures 4-5) and flip chips 204a, 204b with high temperature solder balls 206 (Figures 3-4). The power device package 200 further includes a flexible circuit 208, which may comprise any desirable material, such as copper, polyimide, or a thin FR-4 Core Material, that is laminated to a ring carrier 210. Upon being properly aligned in a mold tool (Figure 3), a thermoset epoxy mold compound 212 (Figure 4) fills the mold cavity, encasing and protecting the flip chips 204a, 204b. The flexible circuit 208 may include a thickness approximately 3-6 mils and the ring carrier may include a thickness of approximately 20-40 mils.

As seen in Figure 3, the power device package 200 is manufactured by first placing at least one flip chip, being flip chips 204a, 204b over the flexible circuit 208 within the mold tool defined by upper and lower mold halves 201, 203. The mold tool also includes a punch 205 that facilitates cutting of a Teflon film 207 dispensed from rollers 209 about the upper mold half 201 and lower mold half 203. The Teflon film 207 may be secured to the upper and lower mold halves 201, 203 by a vacuum or adhesive. According to one aspect of the invention, an MCM including flip chips 204a, 204b of varying heights may be consistently manufactured. More specifically, as seen in then illustrated embodiment, the flip chip 204a includes a height, H1, that is greater than a height, H2, of flip chip 204b. Upon closing of the upper mold 201 upon the lower mold 203, the thermoset epoxy mold compound 212 is injected about the flexible circuit 208 and the flip chips 204a, 204b.

Referring to Figures 3 and 5, central passages 214 and perimeter passages 216 in the flexible circuit 208 permits the thermoset epoxy mold compound 212 to fill the entire mold cavity about the flip chips 204a, 204b. More specifically, the thermoset epoxy resin 212 flows through the central passages 214 to underfill the high temperature solder balls 206 underneath the flip chips 204a, 204b as the thermoset epoxy mold compound 212 also flows through the perimeter passages 216 to overmold the flips chips 204a 204b. Besides allowing the simultaneous overmolding of the flip chips 204a, 204b while being underfilled, the absence of the material about the passages 216 also increases the elasticity of the flexible circuit 208 when the mold tool is closed.

The mold tool is closed with approximately 75 tons of force, the mold compound filling/packing pressure is 350-1000 psi. As seen in Figure 4, the closing of the mold tool and underfilling of the thermoset epoxy resin 212 about the passages 214, 216 results in a deformed, flexed portion, F, of the flexible circuit 208. The flexed portion, F, is displaced downwardly in the direction of the arrow, D, such that the top of the flip chip 204a is level with the top of the flip chip 204b that generally rests on an unflexed portion, U, of the flexible circuit 208. Essentially, the upper mold half 201 pushed down on the top of the flip chips 204a, 204b as the thermoset epoxy resin 212 pushes upwardly from the bottom of the flip chips 204a, 204b.

Once the thermoset epoxy resin has cured, the power device package is removed from the mold tool so that Teflon film 207 may be removed from the non-active side, N, and the active side, A, of the power device package 200. Although not required, the Teflon film advantageously prevents the thermoset epoxy resin 212 from sticking to the upper and lower mold halves 201, 203 while also acting as a release film such that the molded power device package 200 may be easily removed from the mold tool. Then, after removal from the mold tool, an array of low temperature solder balls 202 are attached to the bottom side of the power device package 200 and positioned opposite through-hole via 218 extending from flexible circuit 208 and attached to each low temperature solder ball 202. If desired, a gold film may be adhered to the non-active side, N, to provide a solderable surface for an enhanced thermal interface when attaching the power device package to the product case. Although the illustrated embodiment of the invention shows an MCM power device package 200, it is contemplated that the same procedure may be applied to a SCM power device package 200.

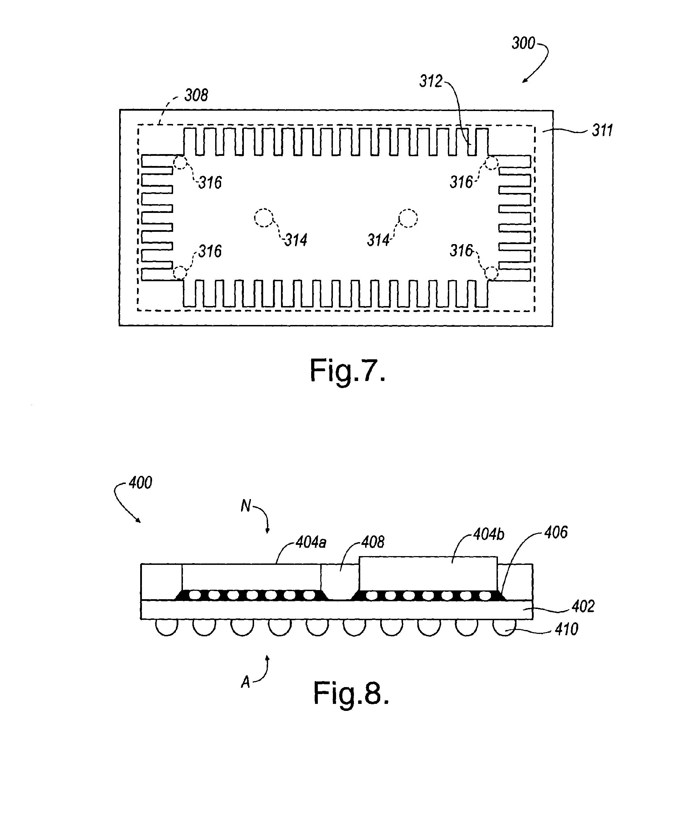

Referring now to Figures 6 and 7, a power device package according to another embodiment of the invention is shown generally at reference numeral 300. The power device package 300 is a QFN package is generally manufactured the same as the BGA power device package 200 as described above with respect to the molding operation. The QFN power device package includes flip chips 304a, 304b that are placed over a flexible circuit 308, which includes central passages 314 and perimeter passages 316, laminated to a ring carrier 310, and a bottom portion 311. As seen more clearly in Figure 7, the bottom portion 311 includes a plurality of QFN connector pads 312 that are electrically coupled to the flexible circuit 308, which is defined by a dashed line perimeter. The bottom portion 311 including the connector pads 312 may be integral with the ring carrier 310, including a sheet of material, such as copper, that is sheared after the molding operation to form the connector pads 312. Alternatively, the sheet defining the bottom portion 311 may be stamped and subsequently adhered to the ring carrier 310.

Referring now to Figure 8, a power device package according to another embodiment of the invention is shown generally at reference numeral 400. The power device package 400 is another BGA package is generally manufactured in the same respect as the BGA power device package 200 in a molding operation, however, the power device package 400 does not include a flexible circuit. As illustrated, the power device package 400 includes flip chips 404a, 404b that are pre-underfilled to an exposed active-side silicon layer 402. The underfilling material may be a thermoset epoxy resin, which is generally seen at reference numeral 406, and, in the molding operation, the overmolding material, which is seen generally at reference numeral 408, may also be a thermoset epoxy resin.

In this embodiment of the invention, the tolerance stack up is compensated for by the Teflon film applied from the rollers 209. As seen, flip chip 404b has a greater height than flip chip 404a such that the top of the flip chip 404b extends from the overmolded material 408. The Teflon film may be any desirable thickness, such as, for example, approximately 5 mils thick and is compressible up to any desirable thickness, such as, for example, approximately 2 mils such that upon removal of the Teflon, flip chips having a tolerance stack up may slightly extend from the overmolded material 408, such as the flip chip 404b. Upon removal of the Teflon film, the low temperature solder balls 410 are added in a subsequent application.

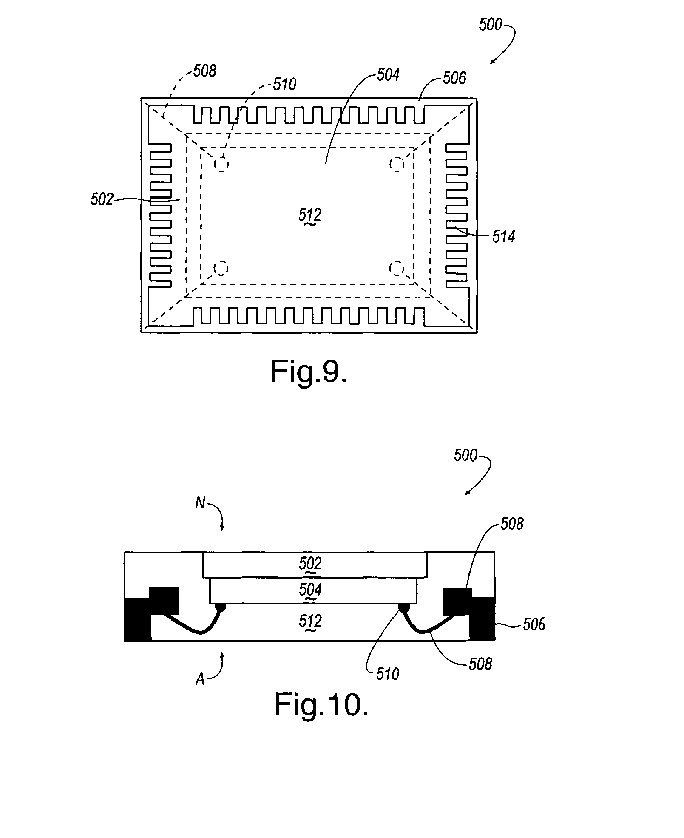

Referring now to Figures 9 and 10, a power device package according to another embodiment of the invention is shown generally at reference numeral 500. The power device package 500 is a QFN package that is generally manufactured the same as the BGA power device package 200 as described above with respect to the molding operation. The QFN power device package 500 differs from the QFN power device package 300 in that the power device package 500 does not include a flip chip. As illustrated, the QFN power device package 500 includes a copper lead frame 502, a silicon IC 504, a copper lead frame wire bond I/O 506 connected to the silicon IC 504 by a gold or aluminum wire 508 and a gold ball bond 510 overmolded with a thermoset epoxy resin 512. Similar in design to the QFN power device package 300, the copper lead frame wire bond I/O 506 may integrally include connector pads 514, or alternatively, the connector pads 514 may extend from a sheet of material, such as copper, that is sheared before or after the molding operation.

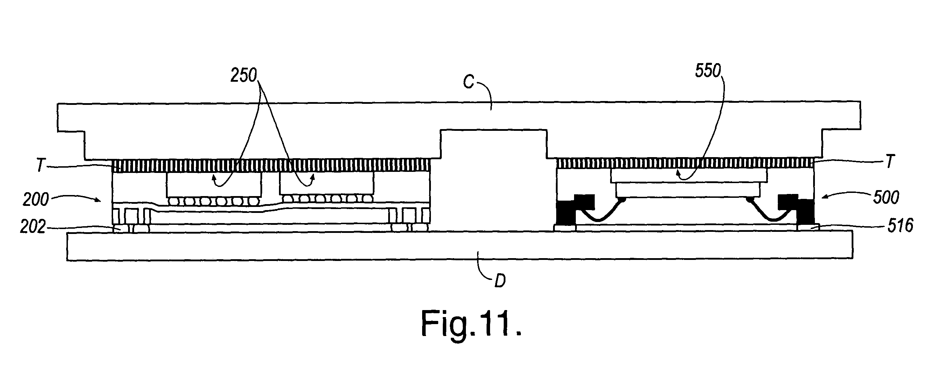

Referring now to Figure 11, a product case, C, including a product case thermal interface, T, is shown. The thermal interface, T, is adjacent to non-active side heat sinks 250, 550 of the power device packages 200, 500, respectively. The thermal interface, T, may be any desirable material such as, for example, a metallic solder, a thermally conductive adhesive, a thermally conductive grease, a thermal film, or the like. The low temperature solder balls 202 and printed solder 516 connects the power device packages 200, 500 to a device, D. The product case, C, may be any type of desirable metal, such as, for example, aluminum or copper. In general, approximately 90-95% of the heat generated by the power device package is evacuated to the thermal interface, T, and out towards the product case, C.

Accordingly, the inventive power device packages includes heat sinks that are directly adjacent to the product case, C, which efficiently permits heat to evacuate the power device packages. Even further, because the heat sinks may be located opposite the I/O at the solder balls (i.e. in a BGA implementation) and printed solder (i.e. in a QFN implementation), heat generated by the power device packages is directed away from the device, D, thus, advantageously lowering the device's operating temperature. Another advantage associated with the inventive power device packages is that the thermal interface, T, is the only thermal interface applied to the power device packages; essentially, the power device packages do not include additional thermally conductive layers and provides a single direct path for heat evacuation.

The present invention has been described with reference to certain exemplary embodiments thereof. However, it will be readily apparent to those skilled in the art that it is possible to embody the invention in specific forms other than those of the exemplary embodiments described above. This may be done without departing from the spirit of the invention. The exemplary embodiments are merely illustrative and should not be considered restrictive in any way. The scope of the invention is defined by the appended claims and their equivalents, rather than by the preceding description.

## Claims

1. A heat sinkable package, comprising:
a power device package (200, 300, 400, 500) including an active side (A) and a non-active side (N), wherein the non-active side (N) includes a heat sinkable surface positioned adjacent to a product case (C).

2. The heat sinkable package according to Claim 1, wherein the power device package (200, 300, 400, 500) includes at least one flip chip (204, 304, 404).

3. The heat sinkable package according to Claim 2, wherein the at least one flip chip (204, 304) is positioned over a flexible circuit (208, 308).

4. The heat sinkable package according to Claim 3, wherein the flexible circuit (208, 308) is laminated to a ring carrier (210, 310).

5. The heat sinkable package according to Claim 3, wherein the flexible circuit (208, 308) is selected from the group consisting of copper, polyimide, and a thin FR-4 Core Material.

6. The heat sinkable package according to Claim 2, wherein the power device package (200, 300, 400, 500) includes a thermoset epoxy resin that underfills high temperature balls (206, 306) of the flip chips (204, 304).

7. The heat sinkable package according to Claim 6, wherein the flexible circuit includes central passages (214, 314) and perimeter passages (216, 316) that permits the simultaneous underfilling and overmolding of the at least one flip chip (204, 304).

8. The heat sinkable package according to Claim 1, wherein the power device package includes a copper lead frame (502), a silicon integrated circuit (504), a copper lead frame wire bond input/output (506) connected to the silicon integrated circuit (504) by a wire (508) and a gold ball bond (510).

9. The heat sinkable package according to Claim 1 further comprising a thermal interface (T) intermediately located between the product case (C) and the non-active side (N).

10. The heat sinkable package according to Claim 9, wherein the thermal interface (T) is selected from the group consisting of a metallic solder, a thermally conductive adhesive, a thermally conductive grease, and a thermal film.

11. The heat sinkable package according to Claim 1, wherein the power device package (200, 300, 400, 500) is a ball grid array package.

12. The heat sinkable package according to Claim 1, wherein the power device package (200, 300, 400, 500) is a quad-flat non-leaded package.

13. A method for manufacturing a heat sinkable package comprising the steps of:
placing at least one flip chip (204, 304) over a flexible circuit (208) within a mold tool;
compensating for height variances of the flip chips (204, 304); and
positioning an input/output on an active side (A) of the power device package (200, 300, 400, 500) opposite a non-active side (N) of the power device package.

14. The method for manufacturing a heat sinkable package according to Claim 13, further comprising the steps of:
closing an upper mold half (201) about a lower mold half (203); simultaneously underfilling and overmolding the flip chips (204, 304) with a thermoset epoxy resin to form a power device package (200, 300, 400, 500).

15. The method for manufacturing a heat sinkable package according to Claim 14, further comprising the step of dispensing a Teflon film (207) about the upper mold half (201) and lower mold half (203) prior to the placing step.

16. The method for manufacturing a heat sinkable package according to Claim 13, wherein the at least one flip chip comprises a first flip chip (204a, 304a) and second flip chip (204b, 304b), wherein the first flip chip (204a, 304a) includes a first height (H1) that is greater than a second height (H2) of the second flip chip (204b, 304b), wherein the compensating step further comprises deforming the flexible circuit (208) such a top portion of the a first flip chip (204a, 304a) is level with a top surface of the second flip chip (204b, 304b).

17. The method for manufacturing a heat sinkable package according to Claim 13 further comprising the step of applying a gold film to the non-active side (N).
